# EUROPÄISCHE PATENTANMELDUNG

(11) **EP 2 256 822 A2**
(43) Veröffentlichungstag der Anmeldung: **01.12.2010**
(21) Anmeldenummer: 10005219.0
(22) Anmeldetag: 19.05.2010
(51) Int. Cl.: H01L 31/042, H01L 31/02

(54) **Safety-Schaltanlage für Solaranlagen**

(30) Priorität: 25.05.2009 DE 102009022508
(71) Anmelder: Eaton Industries GmbH, 53115 Bonn (DE)
(72) Erfinder: Lang, Volker, 53125 Bonn (DE); Linden, Ralph, 51145 Köln (DE); Tharang, Gottfried, 50389 Wesseling (DE)

(57) **Zusammenfassung**

Die Erfindung löst die Aufgabenstellung, eine sichere Abschaltung einer auf einer Einheit wie z.B. einem Wohnhaus montierten Solaranlage kostengünstig zu gewährleisten, wobei die Verbraucher von der Solaranlage galvanisch getrennt sein sollen und die Zuleitungen zu den Verbrauchern im Falle der Abschaltung durch die Safety-Schaltanlage keine Spannungen mehr aufweisen sollen. Es wird eine Safety-Schaltanlage für eine Solaranlage vorgeschlagen, wobei die Solaranlage aus mindestens einem Photovoltaikelement , zwei Anschlüssen zu je einer Zuleitung zu einem Verbraucher besteht, mit einem Bypass , welcher zwischen den beiden Anschlüssen und vor den Zuleitungen angeordnet ist und mindestens einen Schaltmechanismus zum Schließen der Kontaktstellen aufweist, wobei in jeder der beiden Zuleitungen mindestens ein weiterer Schaltmechanismus zum Öffnen der Kontaktstellen angeordnet ist. Die Erfindung ist **dadurch gekennzeichnet, dass** der mindestens eine Schaltmechanismus im Bypass und die in jeder Zuleitung der Photovoltaikanlage sich befindenden weiteren Schaltmechanismen dergestalt angeordnet und über eine Kopplung gemeinsam betätigbar sind, dass beim Betätigen der Safety-Schaltanlage zuerst die Kontaktstelle des mindestens einen Schaltmechanismus in jeder der beiden Zuleitungen geöffnet und anschließend mit einer zeitlichen Verzögerung die Kontaktstellen des mindestens einen Schaltmechanismus, der sich in dem Bypass befindet, geschlossen werden.

## Beschreibung

Die Erfindung betrifft eine Safety-Schaltanlage für eine Solaranlage. Das Solarpanel weist zwei Anschlüsse zu je einer Zuleitung zu einem Verbraucher auf. Ein Bypass, welcher zwischen den beiden Anschlüssen und vor den Zuleitungen angeordnet ist weist mindestens einen Schaltmechanismus zum Kurzschließen des Bypass auf. Ein Schaltmechanismus besteht dabei aus einer Kontaktstelle aus mindestens 2 Kontakten, die über den Mechanismus geöffnet und geschlossen werden können.

Solarpanels werden als Solarenergiequelle eingesetzt und liefern bei Sonneneinstrahlung einen Nutzstrom an angeschlossene Verbraucher. Häufig werden mehrere Solarmodule zu einem Solarpanel zusammengeschlossen und somit die erzeugte Leistung erhöht. Solarpanels werden heute immer häufiger auf privaten und öffentlichen Hausdächern montiert und dienen dann als zusätzliche Energiequelle für private und öffentliche Haushalte.

Im Fall von Wohnungs- oder Hausbränden muss die Feuerwehr dafür sorgen, dass der Einsatzort strom- und spannungslos geschaltet ist, damit zum Beispiel bei Einsatz von Löschmitteln keine Verletzungen durch Stromschläge oder Lichtbögen erfolgen.

Die DE 10 2005 018 173 A1 offenbart ein Verfahren zur sicheren Betriebsunterbrechung einer Photovoltaikanlage mit einer Schutzeinrichtung, welche an die Anschlüsse der Solaranlage angeschlossen ist und einen Bypass zum Kurzschließen der Photovoltaikanlage aufweist. Dieser Bypass kann manuell oder automatisch ausgelöst werden. Je nach Dimension der Photovoltaikanlage können hohe Ströme zu den Verbrauchern bzw. über den Bypass fließen, die im Falle der Auslösung der Schutzeinrichtung beherrscht werden müssen. Daher muss die Schutzeinrichtung entsprechend groß dimensioniert sein. Die Schaltung ist komplett mit elektronischen Halbleiterbauelementen aufgebaut. Die Anlage ist daher nicht galvanisch von den Verbrauchern getrennt. Falls eine Zuleitung defekt sein sollte, findet keine Trennung der Anlage statt.

Die DE 20 2006 007 613 U1 offenbart eine Brandschutzsicherung für eine Photovoltaikanlage, wobei jede Zuleitung jeweils eine unterbrechbare Übergabestelle aufweist. Nach erfolgter Unterbrechung sind zwar die Verbraucher von der Photovoltaikanlage getrennt, zwischen den Zuleitungen bis zur Übergabestelle können aber nach wie vor hohe und damit gefährliche Spannungen auftreten.

Es ist somit Aufgabe der Erfindung, eine sichere Abschaltung einer auf einer Einheit wie z.B. einem Wohnhaus montierten Solaranlage kostengünstig mit galvanischer Trennung zu gewährleisten.

Erfindungsgemäß wird die Aufgabe durch eine Vorrichtung nach Anspruch 1 gelöst. Vorteilhafte Ausführungsformen der Vorrichtung ergeben sich aus den Unteransprüchen.

Die Erfindung betrifft eine Safety-Schaltanlage für eine Solaranlage, wobei das Solarpanel zwei Anschlüsse zu je einer Zuleitung zu einem Verbraucher aufweist, mit einem Bypass, welcher zwischen den beiden Anschlüssen und vor den Zuleitungen angeordnet ist und mindestens einen Schaltmechanismus zum Kurzschließen des Bypass aufweist, wobei in jeder der beiden Zuleitungen mindestens ein weiterer Schaltmechanismus angeordnet ist. Ein solcher Schaltmechanismus weist mindestens eine Kontaktstelle bestehend aus mindestens zwei Kontakten auf, die geöffnet oder geschlossen werden kann. In einem Schaltgerät können mehre solcher Schaltmechanismen angeordnet sein. Die Safety-Schaltanlage besitzt eine Schaltstellung Power, bei der die an das Solarpanel angeschlossenen Verbraucher mit Spannung versorgt werden, und eine Schaltstellung Safety, bei der die Verbraucher von dem Solarpanel getrennt und das Solarpanel kurzgeschlossen ist. Als Verbraucher ist hier auch ein meistens notwendiger Wechselrichter anzusehen.

Es hat sich als besonders vorteilhaft erwiesen, dass die in jeder Zuleitung des Solarpanels befindlichen Schaltmechanismen zum Trennen angeschlossener Verbraucher und der mindestens eine Schaltmechanismus zum Schließen der Kontaktstellen im Bypass des Solarpanels dergestalt miteinander gekoppelt sind, dass sie gemeinsam betätigbar sind, nach der Betätigung aber zuerst die mindestens eine Kontaktstelle des mindestens einen Schaltmechanismus in jeder der beiden Zuleitungen geöffnet und anschließend mit einer zeitlichen Verzögerung die Kontaktstellen des mindestens einen Schaltmechanismus, der sich im Bypass befindet, geschlossen werden, in jedem Fall also gegenläufig geschaltet werden.

Vorteilhafterweise sind die Schaltmechanismen zum Trennen angeschlossener Verbraucher in jeder Zuleitung des Solarpanels und der mindestens eine Schaltmechanismus zum Schließen der Kontaktstellen im Bypass des Solarpanels in zwei von einander getrennten Schaltgeräten, wie z.B. in zwei Lasttrennschaltern, angeordnet. Solche Lasttrennschalter weisen üblicherweise mehrere voneinander getrennte Strombahnen mit jeweils mindestens einem Schaltmechanismus mit jeweils mindestens einer Kontaktstelle auf, so dass die in jeder Zuleitung des Solarpanels befindlichen Schaltmechanismen zum Trennen angeschlossener Verbraucher in einem Gerät verwirklicht werden können.

Die Kopplung der beiden Schaltgeräte kann aus einer geeigneten mechanischen Kopplung bestehen.

Die Betätigung des mindestens einen Schaltmechanismus in jeder der beiden Zuleitungen kann mechanisch über eine Handhabe erfolgen. Als besonders vorteilhaft hat sich erwiesen, den mindestens einen Schaltmechanismus in jeder der beiden Zuleitungen mit einem Auslöser zu schalten. Solche Auslöser können Arbeitsstrom- oder Unterspannungsauslöser sein. Diese Auslöser können manuell zum Beispiel über einen weiteren Schalter aus der Ferne geschaltet werden. Vorteilhafterweise befindet sich dieser Schalter in der Nähe der zentralen Stromversorgung, zum Beispiel eines Hauses, wo die Stromverteilung des Hauses über Sicherungen und Schaltgeräte abgesichert ist. Dies ist häufig ein Kellerraum oder ein separaten Schaltraum. Wird als solcher Auslöser ein Unterspannungsauslöser verwendet, kann dieser mit dem Hausnetz so gekoppelt werden, dass er auslöst, wenn die Spannung hinter der Hausverteilung abfällt. Der besondere Vorteil einer solchen Anordnung ist, dass die Solaranlage automatisch vom Netz getrennt ist, sobald das Haus zum Beispiel durch Ausschalten eines Hauptschalters spannungsfrei ist., ohne dass es einer Hilfsenergie bedarf. Solche Unterspannungsauslöser, als auch die zuvor beschriebenen Arbeitsstromauslöser, sind Standardgeräte und auf dem Markt breit verfügbar. Wird das Schaltgerät zum Trennen der Verbraucher ausgelöst, liegt hinter der Trennstelle keine Spannung mehr an.

Eine besonders bevorzugte Ausführungsform zeichnet sich dadurch aus, dass mindestens zwei schließbare Kontaktstellen im Bypass in Reihe geschaltet sind. Dies kann durch die Verwendung eines entsprechend beschalteten konventionellen Schaltgeräts, wie z.B. einem Lasttrennschalter, ausgeführt werden.

Der wesentliche Vorteil der Erfindung besteht in der Kopplung der beiden Schaltgeräte der Safety-Schaltanlage für die Solaranlage und der Auslösung der Trennung der Solaranlage durch einen mit dem Hausnetz verbundenen Unterspannungsauslöser. Dies bewirkt zum Beispiel im Falle eines Brandes eine schnelle und automatische Abschaltung der Solaranlage vom Hausnetz und den Verbrauchern, sobald das Hausnetz selbst spannungsfrei ist. Das Kurzschließen des Bypass kann durch die Kopplung der beiden Schaltgeräte anschließend mit einer geringen zeitlichen Verzögerung automatisch erfolgen oder aber durch die eine gesonderte, zum Beispiel manuelle Auslösung. Durch die zeitliche Verzögerung der Kurzschließung sind die Verbraucher bereits von dem Solarpanel getrennt und somit der fließende Strom auf Null abgesunken. Die verwendeten Schaltgeräte können somit geringer dimensioniert werden, als wie es bei zeitgleicher Abschaltung und Kurzschließung der Fall sein müsste.

Vorteilhafterweise kann somit der Schalter für die Auslösung des mindestens einen Schaltmechanismus in jeder Zuleitung zu den Verbrauchern in geometrischer Nähe zur Hauptstromverteilung des Gebäudes angeordnet sein, also dort, wo z.B. die Feuerwehr im Brandfall die Stromversorgung des brennenden Gebäudes unterbrechen wird. Der mindestens eine Schaltmechanismus in jeder Zuleitung zu den Verbrauchern selbst und der mindestens eine Schaltmechanismus zum Schließen der Kontaktstellen im Bypass des Solarpanels kann in unmittelbarer Nähe des Solarpanels angeordnet sein, wodurch die Länge der auch nach der Trennung der Verbraucher von dem Solarpanel noch spannungsführenden Leitungen vorteilhaft minimiert wird.

Bei einer solchen Anordnung der Schaltung ist es besonders vorteilhaft, dass Standardschaltgeräte, wie z.B. Lasttrennschalter, verwendet werden können, die als Massengerät produziert zu günstigen Preisen auf dem Markt verfügbar sind.

Es hat sich als vorteilhaft erwiesen, den mindestens einen Schaltmechanismus in jeder der beiden Zuleitungen und den mindestens einen Schaltmechanismus zum Schließen der Kontaktstellen im Bypass des Solarpanels in einem gemeinsamen, zum Beispiel witterungsbeständigen, Gehäuse anzuordnen. Ebenfalls hat es sich als vorteilhaft erwiesen, eine abschließbare Sperre vorzusehen, die verhindert, dass die Safety-Schaltanlage einfach aus der Safety-Stellung in die Power-Stellung geschaltet werden kann. Insbesondere kann eine solche Sperre mit einem Vorhängeschloß in der Safety-Stellung abgeschlossen werden. Umgekehrt kann auch eine zum Beispiel plombierbare Sperre vorgesehen werden, die die mechanische Auslösung des mindestens einen Schaltmechanismus in jeder Zuleitung aus der Power-Stellung in die Safety-Stellung verhindert. Auf diese Art kann eine unberechtigte Bedienung der Safety-Schaltanlage verhindert werden.

Als weiteren Vorteil können die jeweils mindestens einen Schaltmechanismen in jeder Zuleitung und der mindestens eine Schaltmechanismus in dem Bypass Hilfskontakte aufweisen, die es erlauben, den jeweiligen Schaltzustand aus der Ferne abzufragen. Solche Hilfskontakte sind als Standardgeräte auf dem Markt breit verfügbar.

Durch eine Kopplung mit einem weiteren Schaltmechanismus kann das Solarpanel nach dem Kurzschließen zusätzlich geerdet werden, wodurch eine zusätzliche Sicherheit gegen Stromschläge erreicht wird.

Weitere Vorteile, Besonderheiten und zweckmäßige Weiterbildungen der Erfindung ergeben sich aus den folgenden, anhand von Figuren erläuterten Ausführungsbeispielen

Es zeigen:
Fig. 1 eine schematische Darstellung eines Solarpanels;
Fig. 2 eine schematische Darstellung der erfindungsgemäßen Safety-Schaltanlage in der Schaltstellung Power;
Fig. 3 eine schematische Darstellung der erfindungsgemäßen Safety-Schaltanlage in der Schaltstellung Safety;

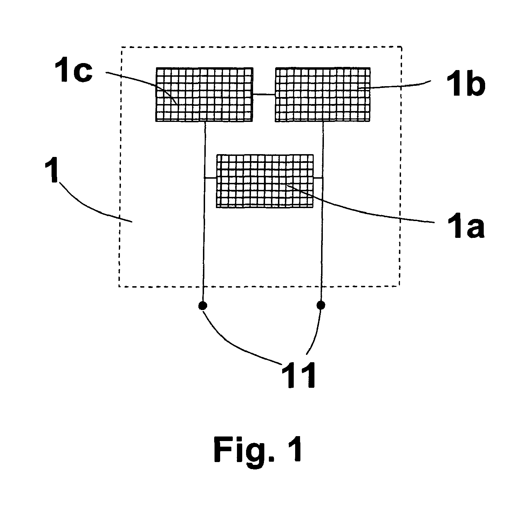

Ein Solarpanel 1 besteht üblicherweise aus mehreren Solarmodulen 1a, 1b. Fig. 1 offenbart ein Solarpanel 1 mit jeweils drei in Reihe geschalteten Solarmodulen 1a, 1b, die ihrerseits parallel geschaltet sind. Alle im Solarpanel befindlichen Solarmodule 1a, 1b sind über zwei Ausgänge 11 kontaktierbar und liefern bei Sonneneinstrahlung elektrische Energie.

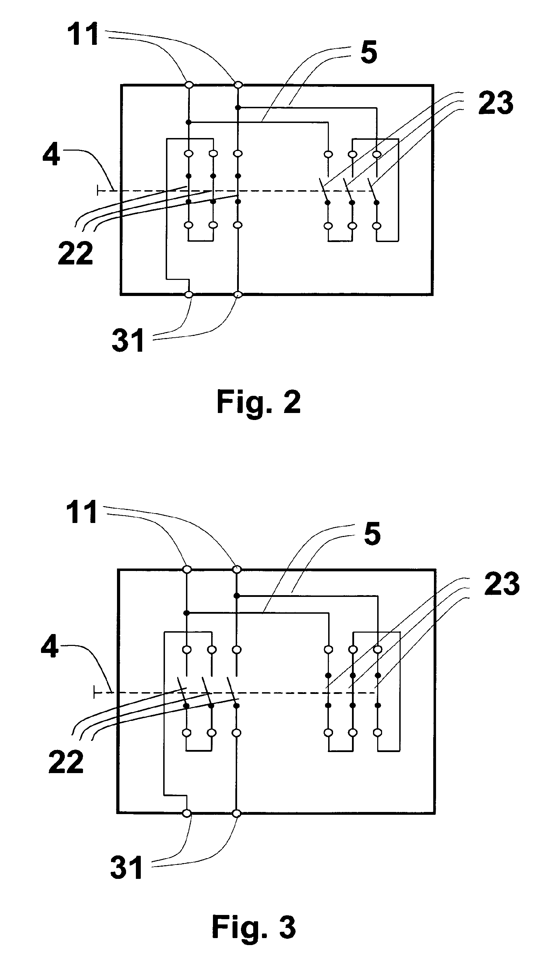

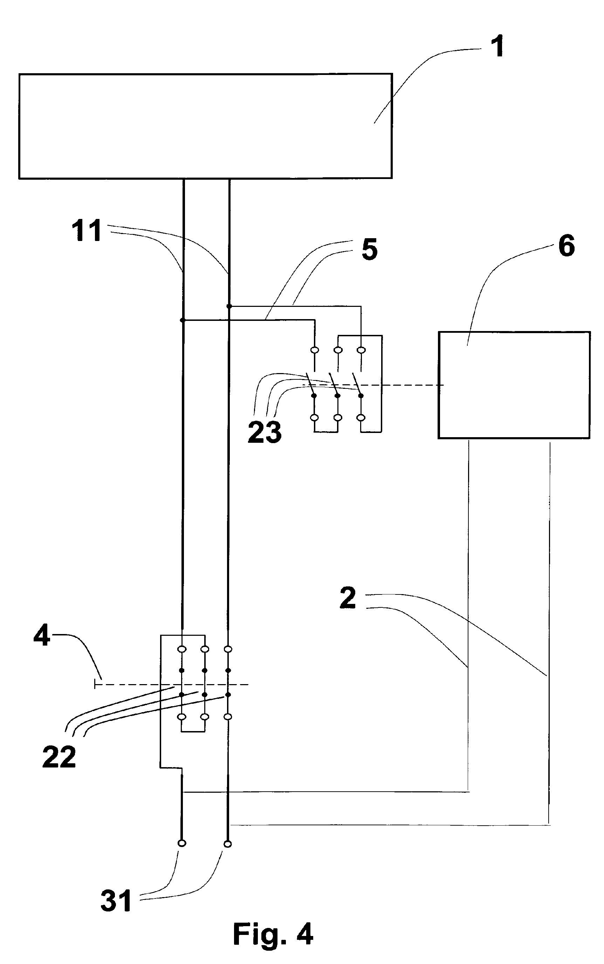

Fig. 2 offenbart eine erfindungsgemäße Safety-Schaltanlage zum sicheren Abschalten der Solaranlage 1 in der Schaltstellung Power. An den Anschlüssen 11 der Solaramöage 1 ist ein Schaltmechanismus 22 zum Öffnen der Kontaktstellen angeordnet. Eine Strombahn dieses Schaltmechanismus 22 weist einen Schaltmechanismus mit einer Kontaktstelle auf, die andere Strombahn dieses Schaltmechanismus 22 weist zwei in Reihe geschaltete Kontaktstellen auf. Alle Kontaktstellen dieses Schaltmechanismus 22 sind geschlossen, womit an den Zuleitungen zum Verbraucher 31 eine Spannung anliegt. Weiterhin weist die erfindungsgemäße Safety-Schaltanlage einen Bypass 5 auf, welcher zwischen den beiden Anschlüssen 11 und vor dem mindestens einen Schaltmechanismus 22 angeordnet ist und einen Schaltmechanismus 23 mit drei in Reihe geschalteten Kontaktstellen zum Schließen aufweist. Die Kontaktstellen dieses Schaltmechanismus 23 sind geöffnet. Alternativ können in den Zuleitungen zwischen den Anschlüssen 11 und den Zuleitungen zum Verbraucher 31, sowie in dem Bypass 5 auch mehr oder weniger Kontaktstellen vorhanden sein. Weiterhin ist ein Auslöser 6 gezeigt, der auf den mindestens einen Schaltmechanismus 22 zum Öffnen der Kontaktstellen wirkt und über die Anschlüsse 7 an das Stromnetz des Hauses angeschlossen ist. Dabei befinden sich die Schaltmechanismen 22 und 23 in einem Gehäuse 8 in unmittelbarer Nähe zum Solarpanel 1. Ein optionaler Schalter zum Schalten des Auslösers 6 kann an den Anschlüssen 7 hingegen angeschlossen und vorteilhafterweise dort angebracht werden, wo auch die komplette Stromversorgung, zum Beispiel eines Hauses, untergebracht und über Sicherungen und Schaltgeräte abgesichert ist. Dies ist häufig ein Kellerraum oder ein separaten Schaltraum.

Fig. 3 offenbart eine erfindungsgemäße Safety-Schaltanlage zum sicheren Abschalten der Solaranlage 1 in der Schaltstellung Safety. In dieser Stellung sind alle Kontaktstellen des Schaltmechanismus 22 geöffnet, womit der Stromfluss zum Verbraucher getrennt und an den Zuleitungen zum Verbraucher 31 keine Spannung anliegt. Die Kontaktstellen des Schaltmechanismus 23 sind geschlossen, womit das Solarpanel kurzgeschlossen ist. In Stromflussrichtung hinter dem Bypass liegt daher keine Spannung mehr an.

### Bezugszeichenliste:

- 1: Solarpanel
- 1a, 1b: Solarmodul
- 11: Anschluss für Solarpanel

- 2: Kopplung
- 22: Schaltmechanismus mit öffnenbaren Kontaktstellen
- 23: Schaltmechanismus mit schließbaren Kontaktstellen

- 3: Verbraucher
- 31: Zuleitungen zum Verbraucher

- 4: Handhabe

- 5: Bypass

- 6: Auslöser

- 7: Anschluss zum Hausnetz

- 8: Gehäuse

## Patentansprüche

1. Safety-Schaltanlage für eine Photovoltaikanlage (1), wobei die Photovoltaikanlage (1) aus mindestens einem Photovoltaikelement (1a), zwei Anschlüssen (11) zu je einer Zuleitung (31) zu einem Verbraucher (3) besteht, mit einem Bypass (5), welcher zwischen den beiden Anschlüssen (11) und vor dem mindestens einen Schaltmechanismus (22) angeordnet ist und mindestens einen Schaltmechanismus (23) zum Schließen von Kontaktstellen aufweist, wobei in jeder der beiden Zuleitungen (31) mindestens ein weiterer Schaltmechanismus (22) zum Öffnen von Kontaktstellen angeordnet ist,
**dadurch gekennzeichnet,**
**dass** der mindestens eine Schaltmechanismus (23) im Bypass (5) und die in jeder Zuleitung (31) der Photovoltaikanlage (1) sich befindenden weiteren Schaltmechanismen (22) dergestalt angeordnet und über eine Kopplung (2) gemeinsam betätigbar sind, dass beim Betätigen der Safety-Schaltanlage zuerst die Kontaktstellen des mindestens einen Schaltmechanismus (22) in jeder der beiden Zuleitungen (31) geöffnet und anschließend mit einer zeitlichen Verzögerung die Kontaktstellen des mindestens einen Schaltmechanismus (23), der sich in dem Bypass befindet, geschlossen werden.

2. Safety-Schaltanlage nach Anspruch 1,
**dadurch gekennzeichnet,**
**dass** der mindestens eine Schaltmechanismus (23) im Bypass (5) und die in jeder Zuleitung (31) der Photovoltaikanlage (1) sich befindenden weiteren Schaltmechanismen in voneinander getrennten Schaltgeräten angeordnet sind.

3. Safety-Schaltanlage nach einem der vorhergehenden Ansprüche,
**dadurch gekennzeichnet,**
**dass** die Kopplung der beiden Schaltmechanismen (22), (23) so aufgebaut ist, dass die beiden Schaltmechanismen (22) und (23) gegenläufig geschaltet werden.

4. Safety-Schaltanlage nach einem der vorhergehenden Ansprüche,
**dadurch gekennzeichnet,**
**dass** die Kopplung der beiden Schaltmechanismen (22), (23) durch mechanische Mittel erfolgt.

5. Safety-Schaltanlage nach einem der vorherigen Ansprüche,
**dadurch gekennzeichnet,**
**dass** die Betätigung des Schaltmechanismus (22) mechanisch durch eine Handhabe (4) erfolgt.

6. Safety-Schaltanlage nach einem der Ansprüche 1 bis 4,
**dadurch gekennzeichnet,**
**dass** die Betätigung des Schaltmechanismus (22) ferngesteuert durch einen Auslöser (6) erfolgt.

7. Safety-Schaltanlage nach Anspruch 6,
**dadurch gekennzeichnet,**
**dass** die Betätigung des Schaltmechanismus (22) ferngesteuert durch einen Unterspannungsauslöser (6), der mit dem Hausnetz verbunden elektrisch ist, erfolgt.

8. Safety-Schaltanlage nach einem der vorhergehenden Ansprüche,
**dadurch gekennzeichnet**
**dass** nach erfolgter Schließung der mindestens einen Kontaktstelle des mindestens einen Schaltmechanismus (23) eine Erdung des erzeugten Kurzschlusses erfolgt..

9. Safety-Schaltanlage nach einem der vorhergehenden Ansprüche,
**dadurch gekennzeichnet,**
**dass** mindestens zwei Schaltmechanismen (23) im Bypass (5) in Reihe geschaltet sind.

10. Safety-Schaltanlage nach einem der vorhergehenden Ansprüche,
**dadurch gekennzeichnet,**
**dass** der Bypass (5) in örtlicher Nähe der Solaranlage (1) angeordnet ist.

11. Safety-Schaltanlage nach einem der vorhergehenden Ansprüche,
**dadurch gekennzeichnet,**
**dass** der mindestens eine Schaltmechanismus (22) und der Bypass (5) mit dem mindestens einen Schaltmechanismus (23) zum Schließen von Kontaktstellen in örtlicher Nähe der Solaranlage (1) angeordnet sind.

12. Safety-Schaltanlage nach einem der vorhergehenden Ansprüche,
**dadurch gekennzeichnet,**
**dass** die Schaltmechanismen (22) und (23) in einem gemeinsamen Gehäuse angeordnet sind.

13. Safety-Schaltanlage nach einem der vorhergehenden Ansprüche,
**dadurch gekennzeichnet,**
eine in der Safety-Stellung der Schaltanlage abschließbare Sperre ein einfaches Schalten aus der Safety-Stellung in die Power-Stellung verhindert.

14. Safety-Schaltanlage nach einem der vorhergehenden Ansprüche,
**dadurch gekennzeichnet,**
eine in der Power-Stellung plombierbare Sperre die mechanische Auslösung des Schaltmechanismus (22) aus der Power-Stellung in die Safety-Stellung verhindert.

15. Safety-Schaltanlage nach einem der vorhergehenden Ansprüche,
**dadurch gekennzeichnet,**
der Schaltzustand mindestens eines der Schaltmechanismen (22) und (23) über Hilfskontakte abgefragt werden kann.
